# EUROPEAN PATENT SPECIFICATION

(11) **EP 2 669 411 B1**
(45) Date of publication and mention of the grant of the patent: **12.10.2016**
(21) Application number: 12739533.3
(22) Date of filing: 26.01.2012
(51) Int. Cl.: C30B 29/06, C01B 33/02, C04B 38/06, C30B 11/00, H01L 21/208, H01L 31/04

(54) **SILICON MELT CONTACTING MEMBER AND PROCESS FOR PRODUCTION THEREOF, AND PROCESS FOR PRODUCTION OF CRYSTALLINE SILICON**
SILICIUMSCHMELZE-KONTAKTELEMENT UND VERFAHREN ZU SEINER HERSTELLUNG SOWIE VERFAHREN ZUR HERSTELLUNG VON KRISTALLINEM SILICIUM
ÉLÉMENT DE CONTACT POUR BAIN DE SILICIUM, SON PROCÉDÉ DE PRODUCTION ET PROCÉDÉ DE PRODUCTION DE SILICIUM CRISTALLIN

(30) Priority: 26.01.2011 JP 2011013681; 31.08.2011 JP 2011189677
(43) Date of publication of application: 04.12.2013
(73) Proprietor: Yamaguchi University, Yamaguchi 753-8511 (JP); Tokuyama Corporation, Shunan-shi Yamaguchi 745-8648 (JP)
(72) Inventor: KOMATSU, Ryuichi, Ube-shi, Yamaguchi 755-8611 (JP); ITOH, Hironori, Ube-shi, Yamaguchi 755-8611 (JP); AZUMA, Masanobu, Shunan-shi, Yamaguchi 745-8648 (JP)
(74) Representative: Duckworth, Timothy John
(86) International application number: PCT/JP2012/051669
(87) International publication number: WO 2012/102343

(56) References cited:
- EP-A1- 0 338 914
- WO-A1-2008/035793
- WO-A1-2010/104838
- JP-A- 2005 089 239
- JP-A- 2006 151 722
- JP-A- 2008 143 754
- JP-A- 2008 143 754
- JP-A- 2008 239 438
- US-A1- 2002 035 026
- US-A1- 2005 012 233
- US-A1- 2009 159 230
- CASSIE A B D ET AL: "Wettability of porous surfaces", TRANSACTIONS OF THE FARADAY SOCIETY, BUTTERWORTHS SCIENTIFIC PUBLICATIONS LTD, LONDON, GB, vol. 40, 1 January 1944 (1944-01-01), pages 546-551, XP008120964, ISSN: 0014-7672, DOI: 10.1039/TF9444000546
- STUDART A R ET AL: "Processing routes to macroporous ceramics: a review", JOURNAL OF THE AMERICAN CERAMIC SOCIETY, BLACKWELL PUBLISHING, MALDEN, MA, US, vol. 89, no. 6, 1 June 2006 (2006-06-01), pages 1771-1789, XP002589200, ISSN: 0002-7820, DOI: 10.1111/J.1551-2916.2006.01044.X [retrieved on 2006-05-11]
- DREVET B ET AL: "Wetting, infiltration and sticking phenomena in Si3N4 releasing coatings in the growth of photovoltaic silicon", SOLAR ENERGY MATERIALS AND SOLAR CELLS, ELSEVIER SCIENCE PUBLISHERS, AMSTERDAM, NL, vol. 94, no. 3, 1 March 2010 (2010-03-01), pages 425-431, XP026878452, ISSN: 0927-0248 [retrieved on 2009-11-28]
- LIU Z ET AL: "Investigation on the crystal growth process of spherical Si single crystals by melting", JOURNAL OF CRYSTAL GROWTH, ELSEVIER, AMSTERDAM, NL, vol. 311, no. 16, 1 August 2009 (2009-08-01), pages 4116-4122, XP026439410, ISSN: 0022-0248 [retrieved on 2009-06-27]
- DREVET B ET AL: "Wetting and adhesion of Si on Si3N4 and BN substrates", JOURNAL OF THE EUROPEAN CERAMIC SOCIETY, ELSEVIER SCIENCE PUBLISHERS, BARKING, ESSEX, GB, vol. 29, no. 11, 1 August 2009 (2009-08-01), pages 2363-2367, XP026139797, ISSN: 0955-2219, DOI: 10.1016/J.JEURCERAMSOC.2009.01.024 [retrieved on 2009-02-27]
- DIAZ A ET AL: "Characterisation of porous silicon nitride materials produced with starch", JOURNAL OF THE EUROPEAN CERAMIC SOCIETY, ELSEVIER SCIENCE PUBLISHERS, BARKING, ESSEX, GB, vol. 24, no. 2, 1 January 2004 (2004-01-01), pages 413-419, XP004479475, ISSN: 0955-2219, DOI: 10.1016/S0955-2219(03)00212-7
- WYNETTE REDINGTON ET AL: "Controlled Porosity in Silicon Nitride", MATERIALS SCIENCE FORUM, vol. 383, 1 January 2002 (2002-01-01), pages 19-24, XP055134791, ISSN: 0255-5476, DOI: 10.4028/www.scientific.net/MSF.383.19
- LIU ZHENGXIN ET AL: "Seeding method with silicon powder for the formation of silicon spheres in the drop method", JOURNAL OF APPLIED PHYSICS, AMERICAN INSTITUTE OF PHYSICS, US, vol. 101, no. 9, 3 May 2007 (2007-05-03), pages 93505-093505, XP012098473, ISSN: 0021-8979

## Description

This invention relates to a silicon melt contact member advantageous for producing crystalline silicon for use in a solar cell or the like, a process for production of the silicon melt contact member, and further a process for production of crystalline silicon by use of the silicon melt contact member. More specifically, the invention relates to a silicon melt contact member having on its surface a porous sintered body layer markedly improved in liquid repellency to a silicon melt formed by melting.

### Background Art:

Crystalline silicon (Si) used as a material for a solar cell is used in 85% or more of all solar cell products. Since the solar cell does not involve emissions of global warming greenhouse gases, its demand has rapidly increased in recent years as a power generation method friendly to the global environment. Compared with other methods of power generation, such as thermal power generation, however, power generation by the solar cell entails a high cost of power generation (yen/W). Reduction of this high cost is earnestly demanded.

Crystalline siliconhas so far been produced as cylindrical or block-shaped crystals from a silicon melt by a crystal growth method such as the Czochralski method or the floating zone method. For use as a material for a solar cell, these crystals need to be cut into the shape of a wafer. During this cutting step, however, 50% or more of the resulting crystalline silicon turns into a waste such as swarf (a cutting loss), constituting one of obstacles to cost reduction.

In an attempt to eliminate the cutting loss of crystalline silicon and reduce the production cost, a method for production of spherical crystalline silicone is under development. This method is a method for producing spherical crystalline silicon by dropping a constant amount of a silicon melt from a high place through utilization of the nature of the melt to become spherical under surface tension. A proposal has been made for a solar cell of a structure in which spheres of the crystalline silicon are arranged on a plane, and the efficiency of power generation can be increased if an effective method of concentrating sunlight is worked out.

However, the spherical crystalline silicon obtained by the method of dropping from a height (dropping method) is in a fine polycrystalline form because of a great temperature gradient during production. This spherical polycrystalline silicon shows a low power generation efficiency, and has a high proportion of crystal defects. Thus, it has become a common practice to reheat the spherical silicon obtained by the dropping method to melt it, and then cool the melt, thereby decreasing the number of the crystal grains of the polycrystalline silicon forming the spherical crystalline silicon. This practice poses the problem of increasing the number of steps to raise costs.

Production of spherical crystalline silicon by a different method, rather than the dropping method, is also under consideration. Patent Document 1, for example, describes a method which comprises accommodating powdery silicon in cavities of a container formed from a high purity ceramic material, quartz glass or the like, heat-melting the powdery silicon, and then solidifying the melt to produce spherical crystalline silicon. The surface of the container is coated with a substance minimally wettable with the silicon melt to form a mold release layer.

Patent Document 2 describes a method which comprises placing a silicon material in concave portions of the surface of a base plate, heat-melting the silicon material, and then solidifying the melt to produce spherical crystalline silicon. The surface of the concave portions of the base plate has, deposited and formed thereon, a film of silicon oxide or the like which is minimally wettable with the silicon melt.

US 2009/0159230 describes a mold forming and molding technology to produce a silicon ingot, wherein a slurry is prepared comprising particles with surface oxide layers operable to bond the particles to each other, an external force is applied to the slurry to eliminate cohesion of the particles to form a de-cohesive slurry, and an inner surface of a mold base is coated with the de-cohesive slurry to form a releasing layer.

US 2005/012233 describes a ceramic having a porosity of not less than 60% and a pore density of not less than 10⁸ pores/cm³ fabricated from expandable microspheres and a preceramic polymer.

### Prior Art Documents:

### Patent Documents:

Patent Document 1: JP-A-2008-143754
Patent Document 2: JP-A-2008-239438

### Summary of the Invention:

### Problems to be solved by the invention:

As described above, the solar cell using spherical crystalline silicon has the potential to eliminate the cutting loss of crystalline silicon and markedly reduce the manufacturing cost of the solar cell. With the production of spherical silicon by the dropping method, however, decreases in the manufacturing cost cannot be expected much. The production of spherical crystalline silicon by Patent Document 1 or Patent Document 2 poses the following problems:
First, the surface of the container or the base plate, where silicon is to be melted and solidified, is coated with a substance (mold release material), such as silicon nitride, or is covered with a film, which is minimally reactive with a silicon melt, to gain liquid repellency to the silicon melt. However, such layers having liquid repellency are so thin that their durability is problematical. Moreover, if the mold release layer is formed by coating each time crystalline silicon is produced, the steps for manufacture of crystalline silicon increase in number, raising the manufacturing cost. Furthermore, if a defect or the like occurs in the film layer having liquid repellency, deficiencies may be produced in the spherical shapes of the spherical crystalline silicone. Besides, the silicon may seep deep into the base plate and become fixed there, or impurities may enter from the base plate into the crystalline silicon.

It is an obj ect of the present invention to provide a silicon melt contact member which is markedly improved in liquid repellency to a silicon melt, which can retain the liquid repellency permanently, and which is suitable for the production of crystalline silicon. It is another object of the invention to provide a process for efficient production of crystalline silicon, particularly, spherical crystalline silicon having high crystallinity, by use of the silicon melt contact member.

### Means for solving the problems:

The present inventors have focused attention on the wetting properties of silicon melts and the porosity of ceramic materials, and have conducted in-depth studies on the sizes and depths of the pores of porous materials, the space distribution of the pores, fluctuations in the thicknesses of the porous materials, and so on. As a result, they have found that a member having a surface formed from a porous sintered body layer, which comprises a specific material and which has a specific pore structure, shows excellent liquid repellency to a silicon melt, and that even when the member is repeatedly brought into contact with the silicon melt, the characteristics of the member can be maintained for a long term. These findings have led them to accomplish the present invention.

That is, according to the present invention, there is provided a silicon melt contact member having a porous sintered body layer present on a surface thereof, wherein the porous sintered body layer comprises a sintered body obtainable by: molding a mixture to form a molded product, which mixture contains organic particles comprising heat-decomposable resin particles and having an average particle diameter of 1 to 25 µm, and a sinterable powder consisting essentially of silicon nitride; firing the molded product until the organic particles disappear; and further sintering the sinterable powder; wherein the porous sintered body layer has, formed therein, pores derived from shapes of the organic particles, the pores having an average equivalent circle diameter of 1 to 25 µm and being dispersedly present in a surface of the porous sintered body layer at a pore-occupying area ratio of 30 to 80%; wherein the porous sintered body layer is formed on a substrate. Thus, the porous sintered body layer has, dispersed in a surface thereof, pores having an average equivalent circle diameter of 1 to 25 µm at a pore-occupying area ratio of 30 to 80%.

In the invention of the silicon melt contact member described above, it is preferred that
(1) the porous sintered body layer is formed on a ceramic substrate;
(2) a surface of the substrate where the porous sintered body layer is formed is composed of silicon nitride;
(3) the thickness of the porous sintered body layer is 5 to 500 µm;
(4) the porous sintered body layer contains silicon dioxide in a proportion of 2 mass % or more, but less than 50 mass %; and
(5) the average depth of the pores present in the surface of the porous sintered body layer is 5 µm or more.

According to the present invention, there is also provided a process for production of crystalline silicon, comprising cooling a silicon melt on a surface of the porous sintered body layer of each of the silicon melt contact members to crystallize the silicon melt.

In the invention of the process for production of crystalline silicon described above, it is preferred that
(1) the silicon melt is obtained by melting solid silicon on the porous sintered body layer;
(2) the crystalline silicon is spherical crystalline silicon, the silicon melt is allowed to exit in the state of droplets on the surface of the silicon melt member, and the silicon melt is cooled in a state of sphericity imparted by its surface tension to carry out crystallization; and
(3) the crystalline silicon is plate-shaped crystalline silicon, two silicon melt members are used, and the silicon melt is cooled while being sandwiched between the two silicon melt members, with the porous sintered body layer of each member being directed inward, to carry out crystallization.

According to the present invention, there is further provided a process for production of a silicon melt contactmember, comprising: coating a dispersion for a sintered body on a substrate, the dispersion containing in an organic solvent a sinterable powder consisting essentially of a silicon nitride powder, and 40 to 400 parts by volume, with respect to 100 parts by volume of the sinterable powder, of heat-decomposable resin particles having an average particle diameter of 1 to 25 µm; then removing the organic solvent by drying; then removing the heat-decomposable resin particles by thermal decomposition; and further sintering the sinterable powder at a temperature of 1100 to 1700°C to form a porous sintered body layer. In the invention of the process for production of a silicon melt contact member, it is preferred that
(1) a surface of the substrate where the porous sintered body layer is formed is composed of silicon nitride; and
(2) the sinterable powder consisting essentially of a silicon nitride powder contains silicon dioxide in a proportion of 2 mass % or more, but less than 50 mass %.

### Effects of the invention:

The silicon melt contact member of the present invention has at least a surface thereof comprising the porous sintered body layer consisting essentially of silicon nitride, and exhibits excellent liquid repellency to the silicon melt.

When the porous sintered body layer is formed on the substrate such as a ceramic substrate, moreover, deformation, cracking or the like occurs with more difficulty than when the member is composed of the porous sintered body only. Besides, the porous sintered body layer shows excellent liquid repellency to the silicon melt. By using such a member as a member for production of crystalline silicon, therefore, spherical crystalline silicon or large plate-shaped crystalline silicone can be produced arbitrarily and efficiently on a shaping surface of a large area.

When used as the member for production of crystalline silicon, moreover, the above member has excellent liquid repellency to the silicon melt as described above. Thus, the effects are also obtained that there is a narrow surface of contact between the member and the silicon melt, and the resulting crystalline silicon is minimal in the inclusion of impurities. Furthermore, the member has the sintered body as its surface, and so can be repeatedly used, unchanged, for the production of crystalline silicone, thus ensuring high industrial value.

### Brief Description of the Drawings:

[Fig. 1] is photographs of silicon, as a raw material, before and after melting.
[Figs. 2(a) to 2(c)] are schematic views showing the outline of a process for production of spherical crystalline silicon in Example 1.
[Figs. 3(a) to 3(c)] are schematic views showing the outline of a process for production of spherical crystalline silicon in Example 5.
[Fig. 4] is an SEM photograph of the surface of a silicon melt contact member obtained in Example 1 (Sample No. 10).
[Fig. 5] is an SEM photograph of the surface of the member obtained in Comparative Example 1 (Sample No. 2).
[Fig. 6] is a stereoscopic micrograph of plate shaped crystalline silicon produced using the silicon melt contact member of Example 1.
[Fig. 7] is a stereoscopic micrograph of plate-shaped crystalline silicon produced using the silicon melt contact member of Comparative Example 1.
[Fig. 8] is a stereoscopic micrograph of spherical crystalline silicon produced using the member of Comparative Example 1 (Sample No. 2).
[Fig. 9] is a stereoscopic micrograph of spherical crystalline silicon produced using a silicon melt contact member of Example 4 (Sample No. 7).
[Fig. 10] is a stereoscopic micrograph of spherical crystalline silicon produced using a silicon melt contact member of Example 4 (Sample No. 8).
[Fig. 11] is a stereoscopic micrograph of spherical crystalline silicon produced using a silicon melt contact member of Example 4 (Sample No. 9).
[Figs. 12 (a) to 12(c)] are schematic views showing the outline of a process for production of plate-shaped crystalline silicon in Example 1.
[Figs. 13 (a) to 13(c)] are schematic views showing the outline of a process for production of plate-shaped crystalline silicon in Example 5.
[Fig. 14] is an SEM photograph of the surface of a silicon melt contact member obtained in Example 5.
[Fig. 15] is an SEM photograph of a cross section of the silicon melt contact member obtained in Example 5.
[Fig. 16] is a view showing the results of focus stacking of the silicon melt contact member obtained in Example 5.
[Fig. 17] is a photograph of the spherical crystalline silicon obtained in Example 5.
[Fig. 18] is a photograph of the plate-shaped crystalline silicon obtained in Example 5.
[Fig. 19] is an SEM photograph of the surface of a silicon melt contact member obtained in Example 6.
[Fig. 20] is an SEM photograph of a cross section of the silicon melt contact member obtained in Example 6.
[Fig. 21] is a view showing the results of focus stacking of the silicon melt contact member obtained in Example 6.
[Fig. 22] is a photograph of spherical crystalline silicon obtained in Example 6.
[Fig. 23] is an SEM photograph of a cross section of a silicon melt contact member obtained in Example 7.

### Mode for Carrying Out the Invention:

### [Silicon melt contact member]

The silicon melt contact member of the present invention is characterized by having a porous sintered body layer present at least on a surface thereof, wherein the porous sintered body layer is obtained by firing a molded product of a mixture, which contains organic particles comprising heat-decomposable resin particles and a sinterable powder consisting essentially of silicon nitride, until the organic particles disappear; and further sintering the sinterable powder, and wherein the porous sintered body layer has, formed therein, pores derived from the shapes of the organic particles. The feature that the porous sintered body layer consists essentially of silicon nitride is necessary to exhibit, in combination with the structure of the pores to be described later, excellent liquid repellency to a silicon melt. Preferably, the proportion of silicon nitride in the porous sintered body layer is 55 mass % ormore, particularly 70 mass % or more.

In the porous sintered body layer, a component other than the silicon nitride is not limited, as long as it can constitute a sintered body. However, a component having the function of suppressing shrinkage during sintering and maintaining the shapes of the resulting pores in the manufacturing process to be described later, concretely, silicon dioxide, is preferred. Preferably, the silicon dioxide is in a proportion of 2 mass % or more, particularly 10 mass % or more, in order to show a shrinkage suppressing effect. If too high a proportion of the silicon dioxide exists, the liquid repellency of the silicon nitride to the silicon melt declines. Thus, the preferred proportion of the silicon dioxide is less than 50 mass %, particularly 45 mass % or less, and further 30 mass % or less.

In the surface of the porous sintered body layer of the present invention, pores having an average equivalent circle diameter of 1 to 25 µm are present in a dispersed state at a pore-occupying area ratio of 30 to 80% as pores derived from the shapes of the aforementioned organic particles.

In the surface of the porous sintered body layer, the ratio of the area where the pores were present (may hereinafter be referred to as the pore-occupying area ratio) was calculated using the image processing software (trade name: A Zou-kun; literally, "Mr. Image A") of Asahi Kasei Engineering Corporation based on electronic data from a photograph taken under a scanning electron microscope. The method of calculation was to select any range to be analyzed, classify this range into portions where the pores were present, and other portions by binary processing, obtain the areas of the respective portions, and add up the numbers of pixels contained in these areas. The area containing all the pores was divided by the total area (the sum of the area where the pores were present and the area where no pores were present) to calculate the ratio of the area where the pores were present. The average equivalent circle diameter was calculated as an average value obtained based on the image of the photograph.

The porous sintered body layer of the present invention gains liquid repellency (non-wettability) to the silicon melt, because it is characterized by the material consisting essentially of silicon nitride and the presence of the pores, and enables spherical or plate-shaped crystalline silicon (to be described later) to be produced repeatedly. The silicon melt contact member of the present invention has a contact angle of 140 degrees or more with respect to the silicon melt, and this value means very great liquid repellency.

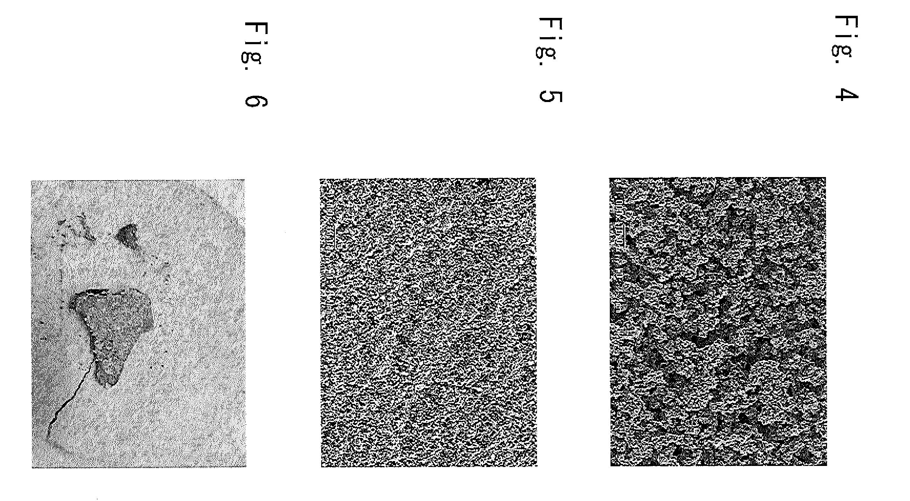

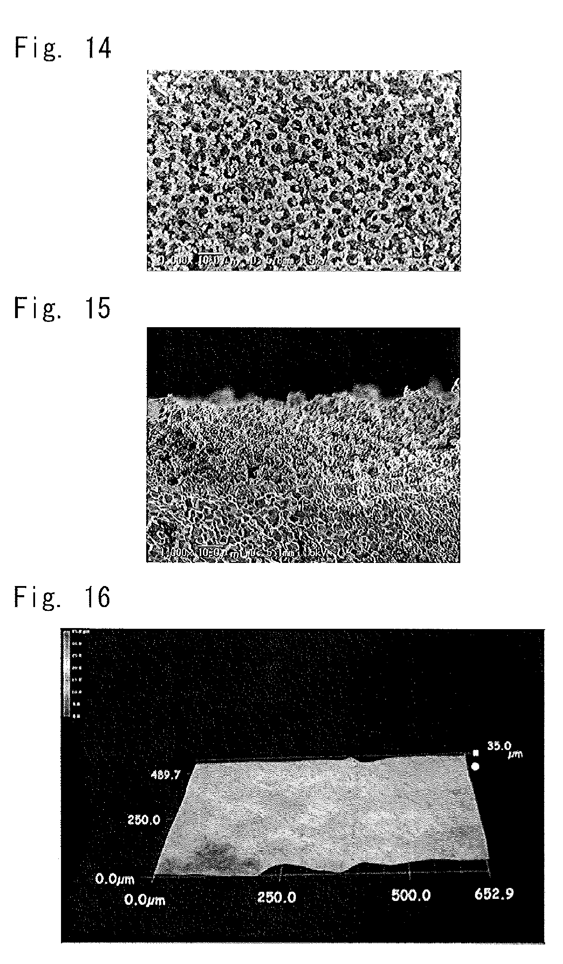

The porous sintered body layer of the present invention has many pores present dispersedly in its surface, as shown in Fig. 4 and Fig. 14. Each pore is present independently in a circular form, but some of the pores are present in a form of plural pores connected together.

These pores have an average equivalent circle diameter of 1 to 25 µm, preferably 2 to 15 µm, on the average when the surface of the porous sintered body layer is viewed directly from above. That is, if the average equivalent circle diameter is less than 1 µm, the undesirable situation occurs that the silicon melt is apt to seep into the porous sintered body by capillarity, leading to a decrease in liquid repellency to the silicon melt. The average equivalent circle diameter in excess of 25 µm is not preferred, because the silicon melt tends to enter the inside of the pores under its own weight.

If the "pore-occupying area ratio" of the pores formed in the surface of the porous sintered body layer is less than 30%, the area of contact between the surface of the porous sintered body layer and the silicon melt increases to pose difficulty in exhibiting sufficient liquid repellency. If the pore-occupying area ratio exceeds 80%, the area which contacts and supports the silicon melt decreases, facilitating the entry of the silicon melt into the pores. Moreover, the strength of the porous sintered body layer tends to lower markedly.

As long as the silicon melt contact member of the present invention has the porous sintered body layer (that is formed on a substrate) in its surface, other structure thereof is not limited.

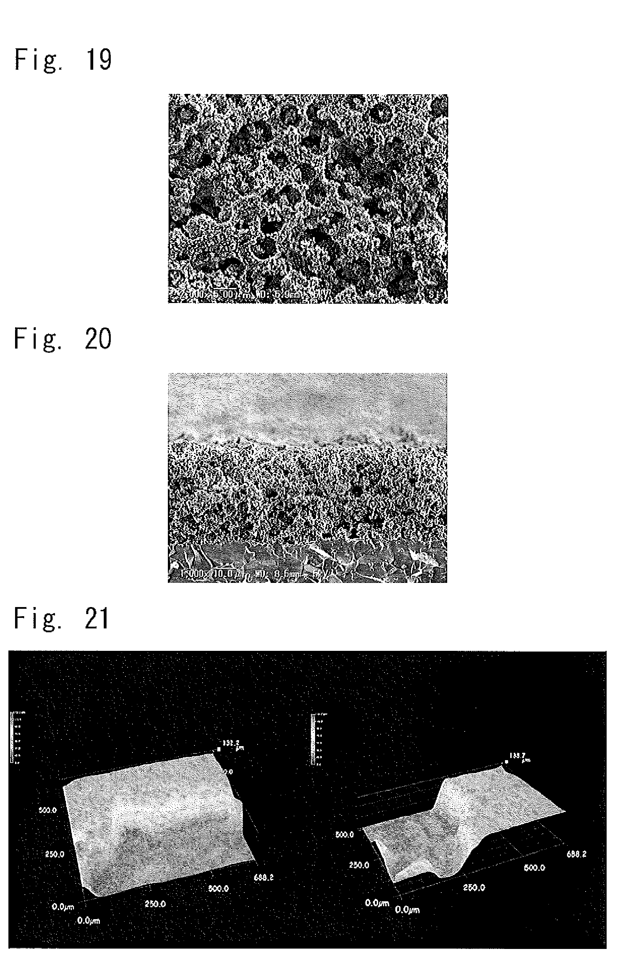

The respective pores present in the porous sintered body layer usually form communicating holes in the depth direction. When the porous sintered body layer is formed on a ceramic substrate, for example, communicating holes are formed in the depth direction, as shown in Fig. 15 and Fig. 20, and these communicating holes start at the surface of the porous sintered body layer and reach as far as the ceramic substrate. The depth of the communicating hole (the length in the vertical direction relative to the surface of the sintered body layer) is preferably set at 5 µm or more, particularly 20 µm or more, in order to effectively show the liquid repellency to the silicon melt on the surface of the porous sintered body layer. If the depth of such communicating holes is less than 5 µm, the liquid repellency to the silicon melt tends to decline.

Thus, the thickness of the porous sintered body layer may be designed in consideration of the depth of the communicating holes, and is preferably 10 µm or more, and 20 µm or more further preferably. Too large a thickness of the porous sintered body layer, however, results in the effect leveling off, and is not economical. Thus, its thickness is preferably 500 µm or less.

The surface of the porous sinteredbody layer of the present invention is extremely smooth and, generally, its surface thickness fluctuates in the range of the order of 5 to 7 µm.

In the present invention, the substrate functions as a support for maintaining the strength of the silicon melt contact member. The substrate is not limited as long as its material enables the porous sintered body layer to be formed thereon. A ceramic or a carbon material is used preferably. A publicly known ceramic material can be used as the ceramic. Generally, the ceramic is alumina or aluminum nitride because of highmelting point, strength and easy availability, but silicon nitride or quartz glass can also be used preferably.

The shape of the substrate is not limited, and may be decided on, as appropriate, according to the intended uses. Concretely, any shape, such as the shape of a plate, a crucible or a tube, can be adopted.

The ceramic substrate composed of a ceramic and assuming the shape of a plate will be described in further detail. The thickness of the ceramic substrate is not limited, but its thickness of 0.5 mm or more, preferably 1 mm or more, more preferably 3 mm or more, ensures sufficient function as a substrate. The surface state of the substrate is not limited. If adhesion to the porous sintered body layer formed on the substrate or the smoothness of the surface of the porous sintered body layer is taken into consideration, however, the surface roughness of the substrate is preferably expressed as an Ra value of the order of 1 to 3.0 µm.

If the ceramic substrate comprises a ceramic other than silicon nitride, the surface of the substrate where the porous sintered body layer is formed is preferably composed of silicon nitride. That is, the ceramic substrate and the porous sintered body layer are not necessarily equal in thermal expansion coefficient, and so peeling may occur owing to a difference in thermal expansion coefficient, with the result that both may separate from each other. In this case, the surface of the ceramic substrate is composed of silicon nitride, whereby such problems can be suppressed. The thickness of the surface comprising silicon nitride is usually selected from the range of 2 to 30 µm, preferably 5 to 30 µm. When the surface of the ceramic substrate is formed from silicon nitride, moreover, it is a preferred embodiment to add to the silicon nitride, if desired, silicon dioxide in a suitable amount, e.g., 2 to 50 mass %, as a component for promoting sintering to prevent shrinkage during sintering.

The above-described features about the ceramic substrate and the porous sintered body layer can be applied to a substrate of other shape or other material.

### [Process for production of silicon melt contact member]

The silicon melt contact member of the present invention is basically obtained by molding a mixture for a sintered body to obtain a molded product, the mixture comprising a sinterable powder consisting essentially of a silicon nitride powder, and 40 to 400 parts by volume, with respect to 100 parts by volume of the sinterable powder, of heat-decomposable resin particles having an average particle diameter of 1 to 25 µm; firing the molded product to cause the heat-decomposable resin particles to disappear; and further sintering the sinterable powder at a temperature of 1100 to 1700°C. Pores derived from the shapes of the heat-decomposable resin particles are formed in the resulting sintered body.

A method to be described later, which uses a dispersion for a sintered body obtained by dispersing the above mixture in an organic solvent, is preferred from the points of view of control over the thickness of the porous sintered body layer and easiness of the manufacturing process.

In the method for production of the silicon melt contact member, there are no limitations on the purity, particle diameter, particle size distribution, etc. of the silicon nitride powder serving as the main component of the sinterable powder. However, in view of the purpose of the invention which is the production of crystalline silicon for a solar cell, the purity is preferably 99.99% or higher. The average particle diameter is preferably 0.2 to 1 µm, and a commercially available product having the above-mentioned properties can be used as such.

As for the proportion of the silicon nitride in the sinterable powder, the silicon nitride shows its effects, if it works as a main component, namely, if its proportion exceeds 50 mass %. In order to form the porous sintered body layer showing better liquid repellency to the silicon melt, however, the preferred proportion is 55 mass % or more, particularly 70 mass % or more.

A component other than silicon nitride in the sinterable powder is not limited, if the component is a powder having sinterability. However, the preferred component is a component having the action of promoting sintering and suppressing shrinkage during sintering, concretely, silicon dioxide. That is, if it is attempted to form the porous sintered body layer with the use of a mixture or dispersion for a sintered body which does not contain a silicon dioxide powder, severe shrinkage occurs during sintering after removal of the heat-decomposable resin particles to be described later, and the stable formation of pores is not possible any more. This is not desirable.

In order to produce the effect of suppressing shrinkage during sintering, therefore, such silicon dioxide is preferably used in a proportion of 2 mass % or more, particularly, 10 mass % or more. The presence of too high a proportion of silicon dioxide lowers liquid repellency by silicon nitride to the silicon melt. Thus, the preferred proportion is less than 50 mass %, particularly, 45 mass % or less, further preferably 40 mass % or less.

The purity of the silicon dioxide is preferably 99.99% or higher. The average particle diameter is 0.05 to 2 µm, preferably 0.2 to 1 µm. A commercially available product having such properties can be used unchanged.

The heat-decomposable resin particles are a component which works to form the aforementioned predetermined pores by undergoing a heat decomposition step and a sintering step to be described later. That is, the particle diameters of the heat-decomposable resin particles are reflected in the diameters of pores in the porous sintered body layer after sintering, while the amount of the heat-decomposable resin particles loaded is reflected in the aforementioned pore-occupying area ratio. Thus, resin particles having an average particle diameter of 1 to 25 µm, preferably 3 to 20 µm, need to be used as the heat-decomposable resin particles, and it is necessary to load 40 to 400 parts by volume, with respect to 100 parts by volume of the sinterable powder, of the resin particles so that the ratio of the total area of the pores per reference area of the surface takes a predetermined value.

A heat-decomposable resin constituting the above particles is not limited, as long as it is a resin which thermally decomposes at a predetermined temperature. However, it would not be preferred if the resin remained in the porous sintered body layer after heat decomposition and sintering, and then entered the resulting crystalline silicon to contaminate it. It is preferred for the heat-decomposable resin particles to have a specific gravity equal to or smaller than the specific gravity of the sinterable powder, because when the aforementioned dispersion is coated on the substrate, the heat-decomposable resin particles can exist reliably in the surface of the coating.

Thus, a hydrocarbon resin such as polyolefin or polystyrene, a benzoguanamine-formaldehyde condensate, or an acrylate resin is preferred as the heat-decomposable resin. In particular, the acrylate resin which minimally leaves behind resin-derived carbon after sintering is preferred.

Examples of the acrylate resin are perfect spherical particles of crosslinked polymethyl methacrylate ("MBX series", produced by Sekisui Plastics Co., Ltd.), perfect spherical particles of crosslinked polybutyl methacrylate ("BMX series, produced by Sekisui Plastics Co., Ltd.), particles of methacrylate resin ("Techpolymer IBM-2", produced by Sekisui Plastics Co., Ltd.), perfect spherical particles of crosslinked polystyrene ("SBX series", produced by Sekisui Plastics Co., Ltd.), perfect spherical particles of crosslinked polyacrylate ("ARX series", produced by Sekisui Plastics Co., Ltd.), and perfect spherical particles of crosslinked polymethyl methacrylate ("SSX (monodisperse) series", produced by Sekisui Plastics Co., Ltd.). Since these acrylate resins are available in different particle diameters and particle size distributions, theymaybe used according to the purpose of the present invention.

A dispersion for a sintered body, which has the above-mentioned components dispersed in an organic solvent, is preferably used.

In detail, first of all, the sinterable powder consisting essentially of the silicon nitride powder, and 40 to 400 parts by volume, relative to 100 parts by volume of the sinterable powder, of the heat-decomposable resin particles having an average particle diameter of 1 to 25 µm are dispersed in an organic solvent to prepare a dispersion for a sintered body. Then, the dispersion is coated on the ceramic substrate, whereafter the organic solvent is removed by drying. Then, the heat-decomposable resin particles are thermally decomposed for removal. Then, sintering was performed to form the porous sintered body layer.

In the above production method, a substrate composed of any of the materials illustrated previously is preferably used as the ceramic substrate. When the ceramic substrate comprises a ceramic other than silicon nitride, the method of constituting the surface of the ceramic substrate, on which the porous sintered body layer is formed, from silicon nitride is, for example, to coat a dispersion of the silicon nitride powder, or a mixture of this powder and a silicon dioxide powder, in an organic solvent onto the ceramic substrate, and then calcine the coating at 100 to 700°C.

The organic solvent used is not limited. If the production of crystalline silicon for a solar cell is targeted, however, an easily evaporable organic solvent, which is composed of carbon, hydrogen, and optionally oxygen atoms, is preferred in order to prevent the entry of impurities (atoms). Concretely, hydrocarbon solvents such as toluene, and alcoholic solvents such as n-octyl alcohol and ethylene glycol are exemplified as preferred solvents.

The amount of the above organic solvent used is not limited, and is determined, as appropriate, so that the dispersion for a sintered body has such a viscosity as to be suitable for a coating method to be described later.

In the mixture or dispersion for the sintered body, additives, for example, a sintering aid such as magnesium oxide or yttrium oxide, and a dispersant for ensuring dispersion stability of the dispersion, may be blended, as appropriate, in addition to the aforesaid essential components.

The sequence of mixing, or the method of mixing, the sinterable powder and the heat-decomposable resin particles, further the optionally incorporated additive, and the organic solvent is not limited.

The prepared mixture for a sintered body is molded by a method, such as press molding, to form a molded product. The molded product is first subjected to thermal decomposition of the heat-decomposable resin particles, and then fired at a temperature of 1100 to 1700°C for sintering, to thereby prepare a porous sintered body.

An operation for thermally decomposing the heat-decomposable resin particles in the molded product to eliminate them may be performed during firing intended for sintering. It is preferred, however, to fire the molded product at a temperature, which is 50 to 300°C higher than the thermal decomposition temperature of the heat-decomposable resin particles, before performing sintering, thereby thermally decomposing the heat-decomposable resin particles to eliminate them. As an atmosphere at the time of thermal decomposition, an atmosphere where the heat-decomposable resin particles can be decomposed is used without restriction. Generally, such firing for thermal decomposition is carried out in the presence of oxygen, usually in air, for the effective removal of carbon formed by decomposition.

The molded product having a porous skeleton, which has been formed upon removal of the heat-decomposable resin particles by the above operation, is then heated at 1100 to 1700°C, preferably 1100 to 1550°C, particularly preferably 1400 to 1530°C, for the purpose of sintering, whereby the desired porous sintered body is formed. By adopting such a firing temperature, deformation or cracking in the resulting porous sintered body can be decreased. The sintering is preferably performed under an inert atmosphere, for example, under an atmosphere such as a nitrogen gas. The sintering time is 1 hour or longer, preferably 2 hours or longer. Too long a sintering time may shrink or collapse the pores formed in the surface. Thus, the sintering time is preferably 30 hours or shorter.

When the dispersion for the sintered body is used to form the porous sintered body layer on the substrate, as a support, in the process for manufacturing the silicon melt contact member of the present invention, this dispersion is coated on the surface of the substrate, such as the ceramic substrate, to a predetermined thickness. The coating method is not limited, and a method such as spin coating, dip coating, roll coating, die coating, flow coating, or spraying is adopted. From the viewpoint of the grade of appearance or the control of film thickness, however, the preferred method is spin coating. If a sufficient thickness is not obtained by coating performed once, as in the spin coating technique, the dispersion is coated, then the organic solvent is dried, and then coating is performed again. By this repeated coating method, a layer having a desired thickness can be formed.

After the dispersion for a sintered boy is coated on the substrate to the predetermined thickness, the organic solvent is removed by drying. As regards the conditions for drying, it is preferred to heat the coating at a temperature which is equal to or higher than the boiling point of the organic solvent.

Then, heating is carried out at a temperature equal to or higher than the decomposition temperature of the heat-decomposable resin particles, whereby the heat-decomposable resin particles are decomposed and removed. The outcome is the formation of a layer comprising a porous skeleton derived from the heat-decomposable resin particles. Further, the layer is fired at the aforementioned sintering temperature to form a porous sintered body layer on the substrate.

The removal of the solvent by drying and the removal of the heat-decomposable resin particles, and further the sintering may be performed consecutively within the same device, with the atmosphere gas or the temperature being changed, or may be performed sequentially in different devices.

### [Process for manufacturing crystalline silicon]

On the surface of the porous sintered body layer of the silicon melt contact member according to the present invention, a melt obtained by melting the silicon material is cooled for crystallization, to thereby produce crystalline silicon.

In connection with the silicon melt, a melt separately formed by melting may be placed on the surface of the porous sintered body layer held at a temperature equal to or higher than the melting temperature of silicon. Alternatively, a predetermined amount of solid silicon may be placed on the surface of the porous sintered body layer, and then held at a temperature equal to or higher than the melting point 1414°C of silicon, preferably at 1420 to 1480°C, by a heating means such as a high frequency coil or a resistance heating type heater, for the purpose of melting. The above melting step, a cooling crystallization step after melting, and a post-treatment step such as an annealing step need to be each performed in an inert gas atmosphere maximally decreased in water and oxygen, for example, in a high purity argon gas atmosphere.

The solid silicon is not limited, and a powder, lumps, a crushing product or the like of silicon which has been obtained by the existing production method such as the crystal growth method or the dropping method can be used as the solid silicon. Its crystallinity does not matter. To produce crystalline silicon for a solar cell in accordance with the present invention, it suffices for the purity of solid silicon to be 99.9999% or higher.

Cooling crystallization can be performed by carrying out cooling, as appropriate, in the melt state under conditions which permit crystallization. Generally, it is preferred to cool the melt to about 700°C at a cooling rate of 50 to 300°C/hour. Crystalline silicon obtained by cooling for crystallization is preferably subjected to annealing, in which either a predetermined temperature is maintained during the course of cooling or cooling is followed by reheating to maintain the temperature, in an attempt to decrease crystal strain or defects of grain boundaries to improve crystallinity. The suitable annealing temperature is 900 to 1350°C, and the suitable annealing time is 1 to 24 hours. The annealing is particularly effective if the cooling rate is relatively high.

The manufacturing methods for spherical crystalline silicon and plate-shaped crystalline silicon, respectively, will be described in detail below.

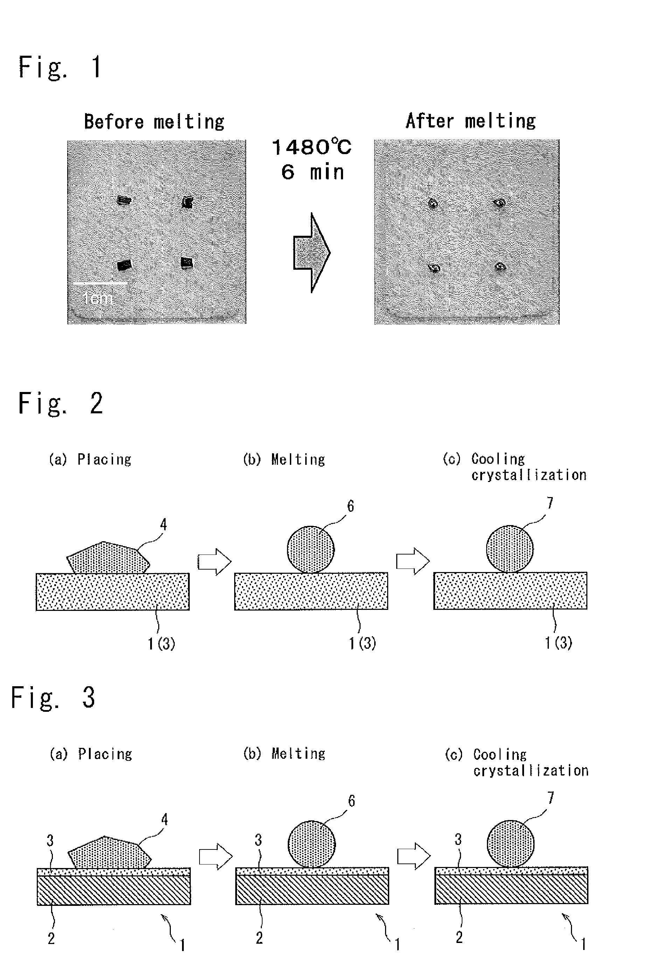

In producing spherical crystalline silicon, pieces of solid silicon are placed at suitable intervals on the surface of the porous sintered body layer of the silicon melt contact member. In this case, the amounts of these pieces placed are preferably adjusted so that the amounts of the individual silicon pieces present on the surface of the porous sintered body layer will be 5 mg to 1 g when converted into the melt. Then, the solid silicon is melted by the aforementioned method, whereby the melt becomes spherical because of the surface tension of the silicon melt and the liquid repellency of the surface of the porous sintered body layer. Fig. 1 shows photographs of the silicon before melting and the spherical form of the silicon after melting.

The supply of the silicon onto the porous sintered body layer is not limited to the supply of the solid form, but can also be performed by dropping a silicon melt, which has been formed by separate melting, onto the surface of the porous sintered body layer, preferably, the surface of the porous sintered body layer heated to the melting point or higher of silicon.

After sphere formation, cooling crystallization, annealing, and cooling are performed by the above-mentioned methods to obtain spherical crystalline silicon. Figs. 2(a) to 2(c) and Figs. 3(a) to 3(c) schematically show the process of manufacturing. Spherical silicon obtained in this manner is crystalline silicon with a marked metallic luster. Its crystal form is often a twin.

The above spherical silicon contains remaining carbon or oxygen atoms, and further remaining nitrogen or iron atoms, at so low concentrations that it can be utilized, in the unchanged state, as crystalline silicon for a solar cell. The sizes of the spherical crystals can be controlled arbitrarily by controlling the amount of the solid silicon used or the intervals between the melts. Normally, spherical crystalline silicon with a particle diameter of 1 to 5 mm can be obtained.

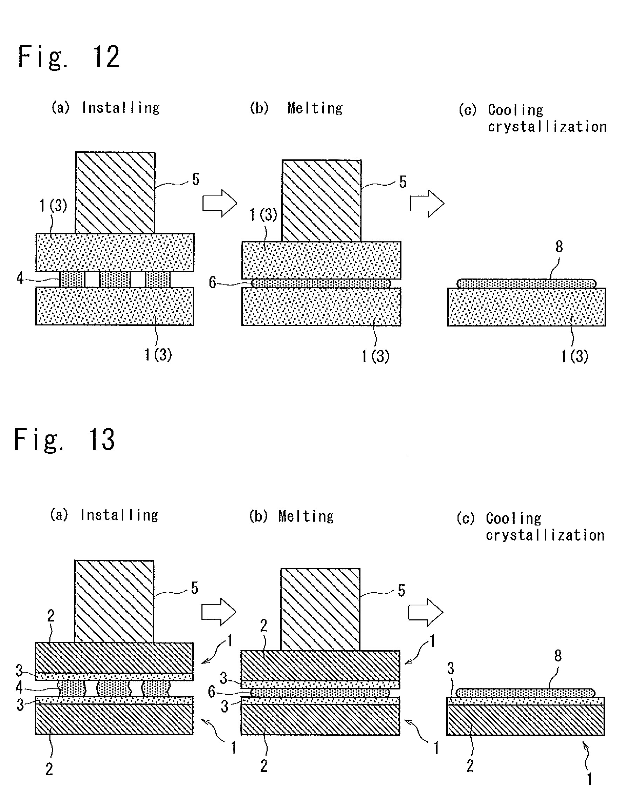

In producing plate-shaped crystalline silicon, on the other hand, solid silicon is sandwiched between the porous sintered body layers of at least two of the silicon melt contact members held horizontally, and is melted, with a weight being placed on the upper silicon melt contact member. Figs. 12 (a) to 12 (c) and Figs. 13 (a) to 13(c) schematically show the process of manufacturing. Moreover, plate-shaped crystalline silicon can also be produced by holding the solid silicon vertically, and applying the unidirectional solidification process. Subsequent steps, including crystallization, are performed in compliance with the method for production of the spherical crystalline silicon. The plate-shaped crystalline silicon can have a size and a thickness controlled by the size or shape of the silicon melt contact member used, the amount of the solid silicon used, and the weight (i.e., heft) of the article used as the weight.

The silicon melt contact member of the present invention is useful not only as a member for the production of the above-mentioned crystalline silicon, but also as a constituent member for a container for dealing with a melt of silicon, for example, a silicon melting crucible, or a casting container for ingot production. In such uses, it is preferred that the silicon melt contact member having the porous sintered body layer formed on the ceramic substrate be used, and a container be composed such that the ceramic substrate of this member serves as a structural material and the porous sintered body layer becomes an inner surface.

### Examples:

Hereinbelow, the present invention will be described specifically by reference to its Examples, but the present invention is in no way limited by these Examples. Moreover, not all of combinations of the features described in the Examples are essential to the means for solution to problems that the present invention adopts.

Example 1 (Reference)

### [Production of silicon melt contact member]

30 Mass % of a silicon nitride powder having a particle diameter of 0.1 to 5 µm, 20 mass % of an amorphous silicon dioxide powder having a particle diameter of 1.8 to 2 µm, and 50 mass % of heat-decomposable resin particles having an average particle diameter of 5 µm (Techpolymer "SSX-105", produced by Sekisui Plastics Co., Ltd.; crosslinked polymethyl methacrylate) were weighed, and mixed in an alumina mortar for 10 minutes. The mixed powder was press molded at 8 kN to form a disk-shaped molded product having a diameter of 20 mm and a thickness of 10 mm. This molded product was heated in the air for 3 hours at 500°C and for 6 hours at 1100°C with the use of a muffle furnace (electric furnace), thereby evaporating and removing spherical particles of the organic compound to obtain a silicon melt contact member (Sample No. 10 in Table 1).

Fig. 4 shows a scanning electron micrograph (SEM) of a surface of a porous sintered body layer of the resulting silicon melt contact member. Its magnification is 1000 times, and a line segment showing a length of 10 µm is indicated on the photograph. The member prepared was confirmed to have pores dispersed in the surface thereof, the pores having an average equivalent circle diameter of 5 µm and present at a pore-occupying area ratio of 60%. The presence of these pores is presumed to enhance liquid repellency to a silicon melt and markedly decrease the seepage of the silicon melt into the silicon melt contact member.

### [Production of spherical crystalline silicon]

A silicon wafer (10 mg) was placed on the resulting silicon melt contact member, and the silicon wafer was melted using a tubular electric furnace. A high purity argon gas (G2) was used as an atmosphere, and water and oxygen were removed by a purification device. The melting of the silicon wafer was performed by holding the silicon wafer for 6 minutes at 1480°C, and the cooling rate was set at 150°C/hour. The silicon solidified into spheres having a diameter of about 2 mm. The contact angle between the silicon melt and the member was about 160 degrees. Peeling of the solidified crystalline silicon from the member was very easy. No seepage of the silicon into the surface of the member was observed. The silicon surface contained few impurities, and took on a metallic luster.

### [Production of plate-shaped crystalline silicon]

Fig. 6 shows the state of the resulting plate-shaped crystalline silicon and the silicon melt contact member used, when the plate-shaped crystalline silicon was produced.

Seepage of the silicon into the surface of the siliconmelt contact member was minimally observed. Even if seepage of silicon into the silicon melt contact member of the present invention slightly occurred, a rub of the surface of the member with a sandpaper would immediately remove the silicon, and thus the depth of the seepage was considered to be tiny. Hence, the silicon melt contact member can be used any number of times.

By changing the conditions for production, various plate-shaped crystalline silicon products measuring 15 mm square and controlled to thicknesses of 250 to 800 µm were obtained successfully.

### Comparative Example 1

### [Production of silicon melt contact member]

Without the addition of heat-decomposable resin particles, 60 mass % of a silicon nitride powder having a particle diameter of 0.1 to 5 µm, and 40 mass % of an amorphous silicon dioxide powder having a particle diameter of 1.8 to 2 µm were weighed, and mixed in an alumina mortar for 10 minutes. The mixed powder was press molded at 8 kN to form a disk-shaped molded product having a diameter of 20 mm and a thickness of 10 mm. This molded product was heated in the air for 3 hours at 500°C and for 6 hours at 1100°C with the use of a muffle furnace, to thereby obtain a sintered body member (Sample No. 2 in Table 1). Fig. 5 shows a scanning electron micrograph (SEM) of a surface of the resulting sintered body member. The surface of the member showed irregularities, but did not indicate the presence of pores.

### [Production of spherical crystalline silicon]

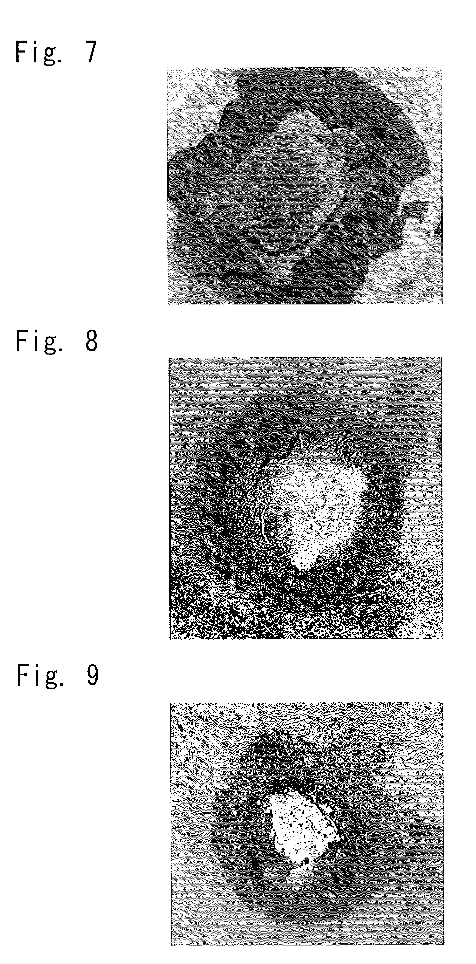

Using the sintered body member prepared, spherical crystalline silicon was produced in the same manner as in Example 1. The crystalline silicon solidified into spheres having a diameter of about 2 mm. The contact angle between the silicon melt and the member was about 160 degrees. Peeling of the solidified silicon from the member was well, but inferior to that in Example 1. Seepage of the silicon into the surface of the member was observed. Almost all of the silicon surface was covered with impurities, and a metallic luster was scarcely observed. A stereoscopic micrograph of the resulting spherical crystalline silicon is shown in Fig. 8.

### [Production of plate-shaped crystalline silicon]

Fig. 7 shows the state of the resulting plate-shaped crystalline silicon and the member used, when the plate-shaped crystalline silicon was produced. Even with the use of this member, plate-shaped crystalline silicon could be prepared, but there was severe seepage of silicon into the surface of the member. Based on these results, the silicon melt contact member of Example 1 proves to be reliably effective in preventing seepage of silicon into it. Observation of a broken-out section of the member undergoing the seepage revealed that the silicon melt penetrated to a depth of at least 170 µm from the surface of the member. Furthermore, it was also observed that the seeping silicon melt reacted with the silicon nitride and silicon dioxide components of the member. Thus, it was extremely difficult to remove the seeping silicon from the member, and it was impossible to utilize the member again.

### Comparative Example 2

Sintered body members were produced in the same manner as in Comparative Example 1, except that the heat-decomposable resin particles were not incorporated, and the material formulations shown in Sample Nos. 1 and 3 of Table 1 were used.

Using each of the resulting sintered body members, spherical crystalline silicon was produced in the same manner. The results are also shown in Table 1.

### Example 2 (Reference)

### [Production of silicon melt contact member]

The proportion of the heat-decomposable resin particles mixed was lower than that in Example 1. That is, a silicon melt contact member was produced (Sample No. 5, Table 1) in the same manner as in Example 1, except that 42 mass % of a silicon nitride powder having a particle diameter of 0.1 to 5 µm, 28 mass % of an amorphous silicon dioxide powder having a particle diameter of 1. 8 to 2 µm, and 30 mass % of heat-decomposable resin particles having an average particle diameter of 5 µm were used. The member prepared was confirmed to have pores dispersed in the surface thereof, the pores having an average equivalent circle diameter of 5 µm and present at a pore-occupying area ratio of 30%.

### [Production of spherical crystalline silicon]

Using the silicon melt contact member prepared, spherical crystalline silicon was produced in the same manner as in Example 1. The crystalline silicon solidified into spheres having a diameter of about 2 mm. The contact angle between the silicon melt and the member was about 160 degrees. Peeling of the solidified crystalline silicon from the member was very easy, and only slight seepage of silicon into the surface of the member was observed. Impurities in the surface of the crystalline silicon were in a somewhat large amount, and there was a little metallic luster. A comparison between Example 2 and Example 1 showed that 50 mass % was desirable as the amount of the heat-decomposable resin particles incorporated.

### Example 3 (Reference)

### [Production of silicon melt contact member]

This is an example in which magnesium oxide (MgO) was added as a sintering aid. 30 Mass % of a silicon nitride powder having a particle diameter of 0.1 to 5 µm, 20 mass % of an amorphous silicon dioxide powder having a particle diameter of 1.8 to 2 µm, and 50 mass % of organic compound spherical particles having an average particle diameter of 5 µm were weighed, followed by adding 3 mass %, based on the entire material system, of magnesium oxide. These materials were mixed in an alumina mortar for 10 minutes. The mixed powder was press molded at 8 kN to form a disk-shaped molded product having a diameter of 20 mm and a thickness of 10 mm. This molded product was heated in the air for 3 hours at 500°C and for 6 hours at 1100°C with the use of a muffle furnace, thereby evaporating and removing heat-decomposable resin particles. Then, the system was fired for 6 hours at 1400°C in a high purity argon (G2) atmosphere to obtain a silicon melt contact member (Sample No. 12 in Table 1). The member prepared was confirmed to have pores dispersed in the surface thereof, the pores having an average equivalent circle diameter of 4 µm and present at a pore-occupying area ratio of 50%.

The incorporation the sintering aid improved the strength of the silicon melt contact member. Moreover, principal firing at 1400°C or higher made it possible to decrease the amount of impurities entering crystalline silicon at the time of crystalline silicon production, and permitted an intrinsic metallic luster of silicon to appear clearly in the surface of the crystalline silicon.

### [Production of spherical crystalline silicon]

Using the silicon melt contact member prepared, spherical crystalline silicon was produced in the same manner as in Example 1. The crystalline silicon solidified into spheres having a diameter of about 2 mm. The contact angle between the silicon melt and the member was about 140 degrees. Liquid repellency was observed to be slightly lower than when no sintering aid was added. Peeling of the solidified silicon from the member was easy, and only slight seepage of the silicon into the surface of the member was observed. The silicon surface contained few impurities, and took on a metallic luster.

### Example 4 (Reference)

Silicon melt contact members were produced in the same manner as in Example 1, except that the material formulations shown in Sample Nos. 4 (Comparative Example - not part of the present invention), 6, 7, 8, 9, 11, 13, 14 and 15 of Table 1 were adopted. The members prepared were confirmed to have pores dispersed in the surfaces thereof, the pores having the average equivalent circle diameters shown in Table 2 and present at the pore-occupying area ratios shown in Table 2. Using each of the resulting silicon melt contact members, spherical crystalline silicon was produced in the same manner as in Example 1. The results are collectively shown in Table 1.

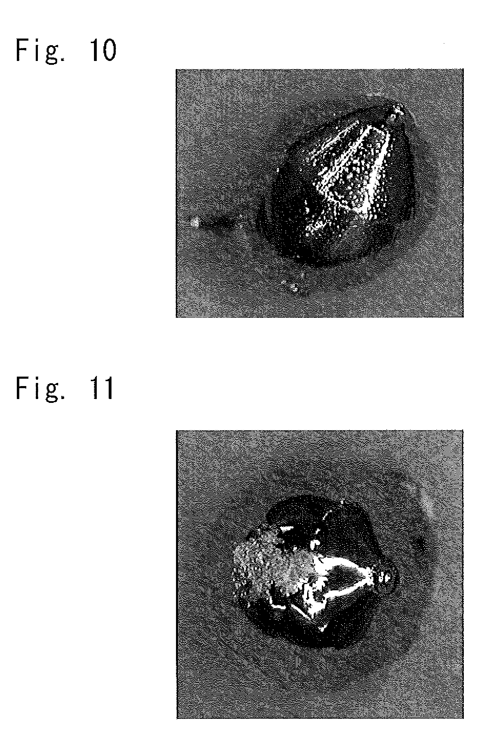

Fig. 9 is a stereoscopic micrograph of the spherical crystalline silicon produced using the silicon melt contact member of Sample No. 7. Fig. 10 is a stereoscopic micrograph of the spherical crystalline silicon produced using the silicon melt contact member of Sample No. 8. Fig. 11 is a stereoscopic micrograph of the spherical crystalline silicon produced using the silicon melt contact member of Sample No. 9. When the silicon melt contact member prepared using the heat-decomposable resin particles was used, there were few impurities on the surface of the crystalline silicon, and a metallic luster was clearly seen. Furthermore, the silicon melt contact member (Sample No.9) involving an increased sintering temperature was found to have a marked metallic luster and contain a smaller amount of impurities.

When spherical crystalline silicon products were manufactured using the members of Sample Nos. 8 and 9, seepage of silicon into the surface of the member was observed, but less than in Sample Nos. 1, 2 and 3.

| Table 1 | | | | | | | | |
|---|---|---|---|---|---|---|---|---|
| Sample No. | 1 | 2 | 3 | 4 | 5 | 6 | 7 | |
| Si₃N₄ (mass %) | 50 | 60 | 70 | 28 | 42 | 56 | 20 | |
| SiO₂ (mass %) | 50 | 40 | 30 | 42 | 28 | 14 | 30 | |
| Heat-decomposable resin particles (mass %) | 0 | 0 | 0 | 30 | 30 | 30 | 50 | |
| Substrate firing temp. (°C) | 1100 | 1100 | 1100 | 1100 | 1100 | 1100 | 1100 | |
| MgO (mass %) | | | | | | | | |
| Seepage | yes | yes | yes | slight | slight | slight | no | |
| Impurities | many | many | many | many | many | many | few | |
| Metallic luster | no | no | no | little | little | little | yes | |
| | | | | | | | | |
| Sample No. | 8 | 9 | 10 | 11 | 12 | 13 | 14 | 15 |
| Si₃N₄ (mass %) | 20 | 20 | 30 | 30 | 30 | 40 | 47.5 | 50 |
| SiO₂ (mass %) | 30 | 30 | 20 | 20 | 20 | 10 | 2.5 | 0 |
| Heat-decomposable resin particles (mass %) | 50 | 50 | 50 | 50 | 50 | 50 | 50 | 50 |
| Substrate firing temp. (°C) | 1480 | 1580 | 1100 | 1400 | 1400 | 1100 | 1100 | 1100 |
| MgO (mass %) | | | | | | | | |
| Seepage | yes | yes | no | no | no | no | no | no |
| Impurities | few | few | few | few | few | few | few | few |
| Metallic luster | yes | yes | yes | yes | yes | yes | yes | yes |
| | | | | | | | | |
| Sample Nos. 1 to 4 are Comparative Examples and Sample Nos. 5 to 15 are Reference Examples | | | | | | | | |
| that are not part of the present invention | | | | | | | | |

**Table 2**

| Sample No. | Pore-occupying area ratio (%) | Average equivalent circle diameter (µm) |
|---|---|---|
| 4 | 25 | 4 |
| 6 | 30 | 5 |
| 7 | 50 | 5 |
| 8 | 50 | 4 |
| 9 | 50 | 4 |
| 11 | 50 | 5 |
| 13 | 50 | 5 |
| 14 | 50 | 5 |
| 15 | 50 | 5 |

Sample No. 4 is a Comparative Example; Sample Nos. 6, 7, 8, 9, 11, 13, 14 and 15 are Reference Examples (not part of the present invention)

### Example 5

### [Production of silicon melt contact member using substrate]

100 Parts by volume of perfect spherical heat-decomposable resin particles having an average particle diameter of 5 µm (Techpolymer "SSX-105", produced by Sekisui Plastics Co., Ltd. ; crosslinked polymethyl methacrylate) was added to 100 parts by volume of a sinterable powder composed of 70 mass % of a silicon nitride powder having an average particle diameter of 0.5 µm (produced by Ube Industries, Ltd.) and 30 mass % of an amorphous silicon dioxide powder having an average particle diameter of 1. 9 µm. Further, 600 parts by mass of ethylene glycol and 0. 05 part by mass of Disperb yk-164 (produced by BYK) which serve as a dispersing agent were added relative to 100 parts by mass of the sinterable powder. These materials were mixed with stirring. During stirring, the viscosity of the dispersion was measured whenever necessary. The dispersion at a time when the viscosity became the lowest was used for the following spin coating as a dispersion for a sintered body:
An aluminum nitride substrate (42x42 mm, thickness 2 mm) was placed on a holding block of a spin coating device ("Rinser Dryer SPDY-1", produced by Tokiwa Vacuum Equipment Co., Ltd.), and the above dispersion was spin coated on the surface of the substrate. The aluminum nitride substrate spin coated with the dispersion was heated for 3 hours at 500°C in the air, and further for 6 hours at 1100°C under a nitrogen atmosphere, with the use of a muffle furnace (electric furnace), to obtain a silicon melt contact member of the present invention.

Fig. 14 shows a scanning electron micrograph (SEM) of a surface of a porous sintered body layer of the resulting member. As shown in Fig. 14, many circular pores (average pore diameter 5 µm) were present nearly uniformly in the surface of the porous sintered body layer. Some of the pores connected together in groups of several pores to form pores of irregular shapes, but most of the pores were individual circular pores. The pore-occupying area ratio of the porous sintered body layer was 50%.

Fig. 15 shows an SEM photograph of a cross section of the silicon melt contact member. As shown in Fig. 15, the thickness of the sintered body layer was about 30 µm, and the pores connected to each other, forming communicating holes. These communicating holes were found to start on the surface of the sintered body layer and reach the surface of the substrate.

Fig. 16 shows the results of focus stacking in which the surface of the porous sintered body layer was analyzed using a CCD microscope device. As show in Fig. 16, the porous sintered body layer was formed on the aluminum nitride substrate, and fluctuations in the thickness of the surface of the sintered body layer were 5 µm at the greatest.

The contact angle of the silicon melt on the surface of the porous sintered body layer of the resulting silicon contact member was measured, and found to be 155 degrees.

### [Production of spherical crystalline silicon]

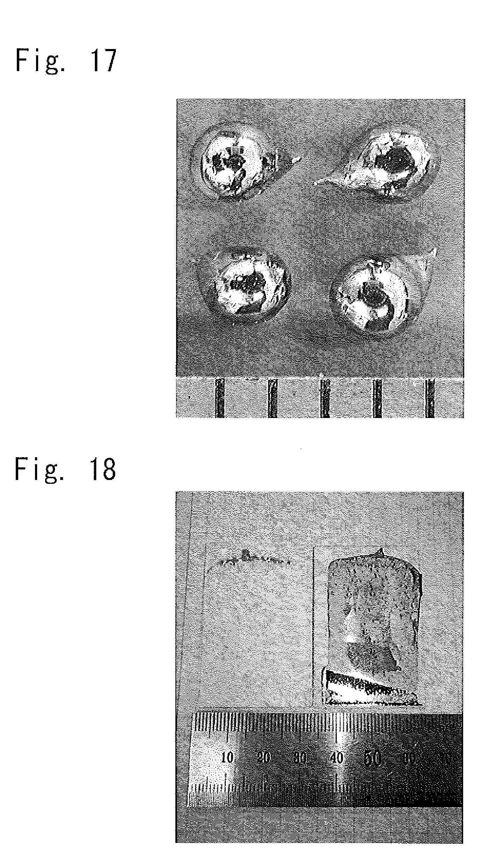

A silicon piece (10 mg) was placed at each of four sites, with a spacing of about 2 cm between the adjacent silicon pieces, on the porous sintered body layer of the silicon melt contact member held in a horizontal posture. The silicon pieces were melted using a tubular electric furnace. An atmosphere was a high purity argon gas (G2) atmosphere deprived beforehand of water and oxygen by a purification device. The melting of the silicon pieces was performed by holding the silicon pieces for 6 minutes at 1480°C, and the cooling rate was set at 150°C/hour. The silicon crystallized and solidified into spheres having a diameter of about 2 mm. Fig. 17 shows a photograph of the resulting spherical crystalline silicon.

The resulting spherical crystalline silicon took on a metallic luster, and its analysis using a secondary ion mass spectroscope (SIMS) showed the spherical crystalline silicon to have an extremely low content of impurities which were carbon, oxygen, nitrogen and iron elements.

### [Production of plate-shaped crystalline silicon]

A silicon piece (3 g) was sandwiched between the porous sintered body layers of two of the silicon melt contact members (42 mm x 42 mm), and subjected to melting and cooling in the same manner as in Example 1 to obtain plate-shaped crystalline silicon.

The resulting crystalline silicon was nearly uniform plate-shaped crystalline silicon measuring 30 mm x 44 mm and having a thickness of 0.908 to 1. 012 mm, and was polycrystalline in terms of crystallinity. Fig. 18 shows a photograph of the resulting plate-shaped crystalline silicon.

The silicon melt contact member used in the above production was used repeatedly, twice or three times, to produce plate-shaped crystalline silicon products. All the products obtained were plate-shaped crystalline silicon products of the same shape. Thus, the member was demonstrated to be excellent in liquid repellency to the silicon melt and have sustainability.

### Example 6

### [Production of silicon melt contact member using substrate]

A silicon melt contact member was prepared in the same manner as in Example 5, except that an alumina substrate (40 mm x 40 mm) was used instead of the aluminum nitride substrate.

Fig. 19 shows an SEM photograph of a surface of a porous sintered body layer of the resulting silicon melt contact member. Fig. 20 shows an SEM photograph of a cross section of the member. Fig. 21 shows the results of focus stacking. In the surface of the porous sintered body layer, circular pores having an average pore diameter of the order of 5 µm were uniformly formed, and the respective pores connected together to form communicating holes in the depth direction, reaching the surface of the substrate. The pore-occupying area ratio of the porous sintered body layer was 60%. Fluctuations in the thickness were 6.7 µm at the largest, showing the formation of a smooth sintered body layer. The contact angle of the silicon melt on the surface of the porous sintered body layer of the resulting silicon melt contact member was measured, and found to be 150 degrees.

### [Production of spherical crystalline silicon]

Spherical crystalline silicon was produced in the same manner as in Example 5 by use of the above silicon melt contact member held in a horizontal state.

A silicon piece (10 mg) was placed at each of nine sites, with a spacing of about 2 cm between the adjacent silicon pieces, on the porous sintered body layer. The same procedure as in Example 5 was performed, except for manufacturing temperature conditions such that the silicon pieces were melted, while being held for 6 minutes at 1480°C, at a heating rate of 200°C/h, and then cooled at 150°C/h for crystallization.

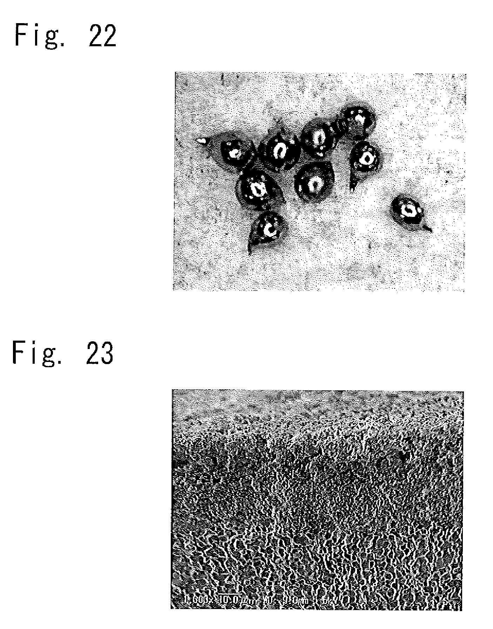

Fig. 22 shows a photograph of the resulting spherical crystalline silicon. The product was confirmed to be spherical crystals measuring about 2 mm and to be crystalline silicon with a high metallic luster.

### Example 7

### [Production of silicon melt contact member using substrate]

As a ceramic substrate to be spin-coated with a dispersion for a sintered body, there was used an aluminum nitride sintered body substrate on whose surface a layer composed of silicon nitride and silicon dioxide was formed by the method to be described below. Except for this condition, the same processing as in Example 5 was performed to prepare a silicon melt contact member.

A sintered body layer surface composed of silicon nitride was formed by spin-coating a dispersion on the aluminum nitride substrate, the dispersion having been prepared by mixing, with stirring, 270 parts by mass of a silicon nitride powder having an average particle diameter of 0.5 µm (produced by Ube Industries, Ltd.), 30 parts by mass of an amorphous silicon dioxide powder (produced by SOEKAWA CHEMICAL CO. , LTD.), and 700 parts by mass of ethylene glycol; and then firing the coating. Subsequently, the same procedure as in Example 5 was performed.

Fig. 23 shows an SEM photograph of a cross section of the silicon melt contact member. The resulting member was a silicon melt contact member of a structure in which a layer comprising silicon nitride and silicon dioxide and having a thickness of 15 µm was laminated on the aluminum nitride sintered body substrate, and a 15 µm porous sintered body layer was further laminated on the layer.

Circular pores having an average pore diameter of the order of 6 µm were formed uniformly in the surface of the porous sintered body layer. The respective pores connected together to form communicating holes in the depth direction, and these communicating holes reached the surface of the substrate. The pore-occupying area ratio of the porous sintered body layer was 60%. Fluctuations in the thickness were 5 µm at the largest, showing the formation of a smooth sintered body layer. The contact angle of the silicon melt on the surface of the porous sintered body layer of the resulting silicon melt contact member was measured, and found to be 150 degrees.

The silicon melt contact member caused peeling of the porous sintered body layer extremely rarely during repeated use, showing high durability.

### Example 8

Silicon melt contact members were produced in the same manner as in Example 1, except that the average particle diameter of the heat-decomposable resin particles used (Techpolymer, produced by Sekisui Plastics Co., Ltd.; crosslinked polymethyl methacrylate), and the proportions of silicon nitride and silicon dioxide constituting the sinterable powder were changed as shown in Table 3.

Using the silicon melt contact members, spherical crystalline silicon products were produced similarly. The results are shown together in Table 3. The contact angles of the respective members to the silicon melt showed nearly the same values as in Example 1. The pores in the porous sintered body layer of each of the resulting silicon melt contact members were virtually circular, and their pore-occupying area ratios and average equivalent circle diameters were as shown in Table 4.

**Table 3**

| Sample No. | 16 | 17 | 18 | 19 |
|---|---|---|---|---|
| Si₃N₄ (mass %) | 30 | 40 | 30 | 30 |
| SiO₂ (mass %) | 20 | 10 | 20 | 20 |
| Techpolymer (mass %) | 50 | 50 | 50 | 50 |
| Techpolymer average particle diameter (µm) | 2 | 2 | 10 | 20 |
| Substrate firing temp.(°C) | 1580 | 1580 | 1580 | 1580 |
| Seepage | no | no | no | slight |
| Impurities | few | few | few | few |
| Metallic luster | yes | yes | yes | yes |

**Table 4**

| Sample No. | Pore-occupying area ratio (%) | Average equivalent circle diameter (µm) |
|---|---|---|
| 16 | 50 | 2 |
| 17 | 50 | 1.5 |
| 18 | 50 | 9 |
| 19 | 50 | 20 |

### Example 9

Silicon melt contact members having an aluminum nitride substrate as a support were produced in the same manner as in Example 5, except that the average particle diameter of the heat-decomposable resin particles used was changed as shown in Table 5.

The pores in the porous sintered body layer of each of the resulting silicon melt contact members were virtually circular, and their average equivalent circle diameters, their pore-occupying area ratios, and the thicknesses of the porous sintered body layers were as shown in Table 5. The contact angles of the silicon melts on the surfaces of the porous sinter body layers of the silicon melt contact members were measured, and shown together in Table 5.

The above silicon melt contact members caused peeling of the porous sintered body layers extremely rarely during repeated use, showing high durability.

**Table 5**

| Sample No. | 20 | 21 | 22 |
|---|---|---|---|
| Si₃N₄ (mass %) | 60 | 60 | 60 |
| SiO₂ (mass %) | 40 | 40 | 40 |
| Techpolymer (mass %) | 50 | 50 | 50 |
| Techpolymer average particle diameter (µm) | 2 | 10 | 20 |
| Substrate firing temp. (°C) | 1100 | 1100 | 1100 |
| Pore-occupying area ratio (%) | 60 | 40 | 40 |
| Average equivalent circle diameter (µm) | 2 | 9 | 20 |
| Thickness of porous sintered body layer (µm) | 25 | 25 | 25 |
| Contact angle (degrees) | 150 | 155 | 148 |

### Explanations of Letters or Numerals:

- 1: Silicon melt contact member
- 2: Ceramic substrate
- 3: Porous sintered body layer
- 4: Solid silicon piece
- 5: Weight
- 6: Silicon melt
- 7: Spherical crystalline silicon
- 8: Plate-shaped crystalline silicon

## Claims

1. A silicon melt contact member having a porous sintered body layer present on a surface thereof, wherein the porous sintered body layer comprises a sintered body obtainable by:
molding a mixture to form a molded product, which mixture contains organic particles comprising heat-decomposable resin particles and having an average particle diameter of 1 to 25 µm, and a sinterable powder consisting essentially of silicon nitride;
firing the molded product until the organic particles disappear; and
further sintering the sinterable powder;
wherein the porous sintered body layer has, formed therein, pores derived from shapes of the organic particles, the pores having an average equivalent circle diameter of 1 to 25 µm and being dispersedly present in a surface of the porous sintered body layer at a pore-occupying area ratio of 30 to 80%;
wherein the porous sintered body layer is formed on a substrate.

2. The silicon melt contact member according to claim 1, wherein a surface of the substrate where the porous sintered body layer is formed is composed of silicon nitride.

3. The silicon melt contact member according to claim 1 or 2, wherein a thickness of the porous sintered body layer is 5 to 500 µm.

4. The silicon melt contact member according to any one of claims 1 to 3, wherein the porous sintered body layer contains silicon dioxide in a proportion of 2 mass % or more, but less than 50 mass %.

5. The silicon melt contact member according to any one of claims 1 to 4, wherein an average depth of the pores present in a surface of the porous sintered body layer is 5 µm or more.

6. A process for production of crystalline silicon, comprising:
cooling a silicon melt on a surface of the porous sintered body layer of the silicon melt contact member according to any one of claims 1 to 5, thereby crystallizing the silicon melt.

7. The process for production of crystalline silicon according to claim 6, wherein the silicon melt is obtained by melting solid silicon on the porous sintered body layer.

8. The process for production of crystalline silicon according to claim 6 or 7, wherein the crystalline silicon is spherical crystalline silicon.

9. The process for production of crystalline silicon according to claim 6, wherein the crystalline silicon is plate-shaped crystalline silicon, the process comprising
using two of the silicon melt contact members, and
cooling the silicon melt, while sandwiching the silicon melt between the two silicon melt contact members, with the porous sintered body layers of the members being directed inward, thereby crystallizing the silicon melt.

10. A process for production of a silicon melt contact member, comprising:
coating a dispersion for a sintered body on a substrate, the dispersion containing in an organic solvent a sinterable powder consisting essentially of a silicon nitride powder, and 40 to 400 parts by volume, with respect to 100 parts by volume of the sinterable powder, of heat-decomposable resin particles having an average particle diameter of 1 to 25 µm;
then removing the organic solvent by drying;
then removing the heat-decomposable resin particles by thermal decomposition; and
further sintering the sinterable powder at a temperature of 1100 to 1700°C to form a porous sintered body layer.

11. The process for production of a silicon melt contact member according to claim 10, wherein a surface of the substrate where the porous sintered body layer is formed is composed of silicon nitride.

12. The process for production of a silicon melt contact member according to claim 10 or 11, wherein the sinterable powder consisting essentially of a silicon nitride powder contains silicon dioxide in a proportion of 2 mass % or more, but less than 50 mass %.

## Patentansprüche

1. Siliciumschmelze-Kontaktelement mit einer porösen, gesinterten Körperschicht, die auf der Oberfläche desselben vorhanden ist, wobei die poröse gesinterte Körperschicht einen gesinterten Körper umfasst, erhältlich durch:
Formen eines Gemisches unter Bildung eines geformten Produkts, wobei das Gemisch organische Partikel enthält, umfassend wärmezersetzbare Harzpartikel und mit einem durchschnittlichen Partikeldurchmesser von 1 bis 25 µm, und ein sinterbares Pulver, welches im Wesentlichen aus Siliciumnitrid besteht;
Brennen des geformten Produkts, bis die organischen Partikel verschwinden; sowie
weiteres Sintern des sinterbaren Pulvers;
wobei die poröse gesinterte Körperschicht darin gebildete Poren aufweist, die von Formen der organischen Partikel abgeleitet sind, die Poren einen durchschnittlichen äquivalenten Kreisdurchmesser von 1 bis 25 µm aufweisen und dispergiert in der Oberfläche der gesinterten Körperschicht mit einem Porenbesetzungsflächenverhältnis von 30 bis 80% vorhanden sind;
wobei die poröse gesinterte Körperschicht auf einem Substrat gebildet ist.

2. Siliciumschmelze-Kontaktelement gemäß Anspruch 1, wobei eine Oberfläche des Substrats, wo die poröse gesinterte Körperschicht gebildet ist, aus Siliciumnitrid besteht.

3. Siliciumschmelze-Kontaktelement gemäß Anspruch 1 oder 2, wobei die Dicke der porösen gesinterten Körperschicht 5 bis 500 µm beträgt.

4. Siliciumschmelze-Kontaktelement gemäß einem der Ansprüche 1 bis 3, wobei die poröse gesinterte Körperschicht Siliciumdioxid in einem Verhältnis von 2 Massen-% oder mehr, jedoch weniger als 50 Massen-% enthält.

5. Siliciumschmelze-Kontaktelement gemäß einem der Ansprüche 1 bis 4, wobei die durchschnittliche Tiefe der in einer Oberfläche der porösen gesinterten Körperschicht vorhandenen Poren 5 µm oder mehr beträgt.

6. Verfahren zur Herstellung von kristallinem Silicium, umfassend:
Abkühlen einer Siliciumschmelze auf einer Oberfläche der porösen gesinterten Körperschicht des Siliciumschmelze-Kontaktelements gemäß einem der Ansprüche 1 bis 5 und dadurch Kristallisieren der Siliciumschmelze.

7. Verfahren zur Herstellung von kristallinem Silicium gemäß Anspruch 6, wobei die Siliciumschmelze durch Schmelzen von festem Silicium auf der porösen gesinterten Körperschicht erhalten wird.

8. Verfahren zur Herstellung von kristallinem Silicium gemäß Anspruch 6 oder 7, wobei das kristalline Silicium sphärisches kristallines Silicium ist.

9. Verfahren zur Herstellung von kristallinem Silicium gemäß Anspruch 6, wobei das kristalline Silicium plättchenförmiges kristallines Silicium ist, wobei das Verfahren umfasst:
Verwenden von zwei der Siliciumschmelze-Kontaktelemente, und
Abkühlen der Siliciumschmelze, während die Siliciumschmelze zwischen die zwei Siliciumschmelze-Kontaktelemente eingeschoben wird, wobei die porösen gesinterten Körperschichten der Elemente nach innen gerichtet sind, wodurch die Siliciumschmelze kristallisiert wird.

10. Verfahren zur Herstellung eines Siliciumschmelze-Kontaktelements, umfassend:
Auftragen einer Dispersion für einen gesinterten Körper auf ein Substrat, wobei die Dispersion in einem organischen Lösungsmittel ein sinterbares Pulver, das im Wesentlichen aus Siliciumnitridpulver besteht, und 40 bis 400 Volumenteile bezüglich 100 Volumenteilen des sinterbaren Pulvers wärmezersetzbare Harzpartikel mit einem durchschnittlichen Partikeldurchmesser von 1 bis 25 µm, umfasst;
anschließend Entfernen des organischen Lösungsmittels durch Trocknen;
anschließend Entfernen der wärmezersetzbaren Harzpartikel durch thermische Zersetzung; und
weiteres Sintern des sinterbaren Pulvers bei einer Temperatur von 1100 bis 1700°C unter Bildung einer porösen gesinterten Körperschicht.

11. Verfahren zur Herstellung eines Siliciumschmelze-Kontaktelements gemäß Anspruch 10, wobei eine Oberfläche des Substrats, auf der die poröse gesinterte Körperschicht gebildet wird, aus Siliciumnitrid besteht.

12. Verfahren zur Herstellung eines Siliciumschmelze-Kontaktelements gemäß Anspruch 10 oder 11, wobei das sinterbare Pulver, das im Wesentlichen aus einem Siliciumnitridpulver besteht, Siliciumdioxid in einem Anteil von 2 Massen-% oder mehr, jedoch weniger als 50 Massen-% enthält.

## Revendications

1. Elément de contact avec une masse fondue de silicium, comportant sur l'une de ses surfaces une couche poreuse en matériau fritté, laquelle couche poreuse en matériau fritté comprend un corps fritté accessible par les opérations suivantes :
- mouler, pour en faire un objet moulé, un mélange qui contient des particules organiques comprenant des particules de résine thermo-décomposable et présentant un diamètre moyen de 1 à 25 µm, ainsi qu'une poudre frittable, essentiellement constituée de nitrure de silicium ;
- calciner cet objet moulé jusqu'à ce que les particules organiques disparaissent ;
- et ensuite, effectuer le frittage de la poudre frittable ;
dans lequel la couche poreuse en matériau fritté présente en son sein des pores dont les formes dérivent de celles des particules organiques, lesquels pores présentent un diamètre moyen de cercle équivalent de 1 à 25 µm et se trouvent dispersés, au niveau de la surface de la couche poreuse en matériau fritté, avec un taux d'occupation de l'aire par les pores de 30 à 80 %,
et dans lequel la couche poreuse en matériau fritté est formée sur un substrat.

2. Elément de contact avec une masse fondue de silicium, conforme à la revendication 1, pour lequel la surface du substrat sur laquelle est formée la couche poreuse en matériau fritté est constituée de nitrure de silicium.

3. Elément de contact avec une masse fondue de silicium, conforme à la revendication 1 ou 2, dans lequel l'épaisseur de la couche poreuse en matériau fritté vaut de 5 à 500 µm.

4. Elément de contact avec une masse fondue de silicium, conforme à l'une des revendications 1 à 3, dans lequel la couche poreuse en matériau fritté contient du dioxyde de silicium, en une proportion de 2 % en masse ou plus, mais inférieure à 50 % en masse.

5. Elément de contact avec une masse fondue de silicium, conforme à l'une des revendications 1 à 4, dans lequel la profondeur moyenne des pores présents à la surface de la couche poreuse en matériau fritté vaut 5 µm ou plus.

6. Procédé de production de silicium cristallin, comportant le fait de faire refroidir une masse fondue de silicium, sur la surface constituée par la couche poreuse en matériau fritté d'un élément de contact avec une masse fondue de silicium, conforme à l'une des revendications 1 à 5, et de faire ainsi cristalliser la masse fondue de silicium.

7. Procédé de production de silicium cristallin, conforme à la revendication 6, dans lequel on obtient la masse fondue de silicium en faisant fondre du silicium solide sur la couche poreuse en matériau fritté.

8. Procédé de production de silicium cristallin, conforme à la revendication 6 ou 7, dans lequel le silicium cristallin est du silicium cristallin en particules sphériques.

9. Procédé de production de silicium cristallin, conforme à la revendication 6, dans lequel le silicium cristallin est du silicium cristallin en particules en forme de plaquettes, lequel procédé comporte :
- le fait d'utiliser deux éléments de contact avec une masse fondue de silicium,
- et le fait de faire refroidir la masse fondue de silicium tout en la maintenant prise en sandwich entre les deux éléments de contact avec une masse fondue de silicium, dont les couches poreuses en matériau fritté sont tournées vers l'intérieur, et de faire ainsi cristalliser la masse fondue de silicium.

10. Procédé de préparation d'un élément de contact avec une masse fondue de silicium, comportant les étapes suivantes :
- étaler en couche, sur un substrat, une dispersion pour corps fritté, laquelle dispersion comprend, dans un solvant organique, une poudre frittable essentiellement constituée de nitrure de silicium en poudre, ainsi que de 40 à 400 parties en volume, pour 100 parties en volume de la poudre frittable, de particules de résine thermo-décomposable et présentant un diamètre moyen de 1 à 25 µm ;
- chasser le solvant organique par séchage ;
- puis éliminer les particules de résine thermo-décomposable, par décomposition thermique ;
- et ensuite, effectuer le frittage de la poudre frittable, à une température de 1100 à 1700 °C, pour former une couche poreuse en matériau fritté.

11. Procédé de préparation d'un élément de contact avec une masse fondue de silicium, conforme à la revendication 10, dans lequel la surface du substrat sur laquelle est formée la couche poreuse en matériau fritté est constituée de nitrure de silicium.

12. Procédé de préparation d'un élément de contact avec une masse fondue de silicium, conforme à la revendication 10 ou 11, dans lequel la poudre frittable essentiellement constituée de nitrure de silicium en poudre contient du dioxyde de silicium, en une proportion de 2 % en masse ou plus, mais inférieure à 50 % en masse.
